# EUROPÄISCHE PATENTSCHRIFT

(11) **EP 2 396 827 B1**
(45) Veröffentlichungstag und Bekanntmachung des Hinweises auf die Patenterteilung: **27.12.2017**
(21) Anmeldenummer: 10705545.1
(22) Anmeldetag: 15.02.2010
(51) Int. Cl.: H01L 31/05, H01L 31/048

(54) **PHOTOVOLTAISCHES MODUL UND VERFAHREN ZU DESSEN HERSTELLUNG**
PHOTOVOLTAIC MODULE AND METHOD FOR THE PRODUCTION THEREOF
MODULE PHOTOVOLTAÏQUE ET PROCÉDÉ DE PRODUCTION

(30) Priorität: 16.02.2009 DE 102009009036
(43) Veröffentlichungstag der Anmeldung: 21.12.2011
(73) Patentinhaber: Fraunhofer-Gesellschaft zur Förderung der angewandten Forschung e.V., 80686 München (DE)
(72) Erfinder: WIRTH, Harry, 79249 Merzhausen (DE)
(74) Vertreter: Pfenning, Meinig & Partner mbB
(86) Internationale Anmeldenummer: PCT/EP2010/000919
(87) Internationale Veröffentlichungsnummer: WO 2010/091889

(56) Entgegenhaltungen:
- EP-A1- 1 959 502
- WO-A2-2008/136872
- DE-A1- 10 356 690
- DE-A1- 19 752 678
- JP-A- 57 172 777

## Beschreibung

Die Erfindung betrifft ein photovoltaisches Modul enthaltend eine erste und eine zweite Deckschicht, eine zwischen diesen befindliche Anordnung von über Zellverbindern verbundenen photovoltaischen Zellen sowie eine das photovoltaische Modul umlaufende Randabdichtung der Deckschichten. Das erfindungsgemäße Modul ermöglicht dabei eine Minimierung der mechanischen Belastungen, z.B. durch unterschiedliche thermische Ausdehnungskoeffizienten, der photovoltaischen Zellen. Ebenso wird ein Verfahren zur Herstellung der erfindungsgemäßen photovoltaischen Module bereitgestellt.

Wafer-basierte Solarzellen müssen zwischen schützenden Deckschichten angeordnet werden. Ihre Fixierung muss die unterschiedlichen thermischen Ausdehnungskoeffizienten zwischen Deckschichtmaterialien, insbesondere Glas, und dem Wafermaterial, Silizium, berücksichtigen. Schließlich muss der Produktionsprozess des Solarmoduls wirtschaftlichen Anforderungen bezüglich Material- und Verarbeitungskosten genügen.

Im Stand der Technik wird diese Aufgabe durch ein Einkapselungsmaterial gelöst, das die Zellen beidseitig umschließt und mit den Deckschichten aus Glas bzw. Rückseitenfolien/Glas verbindet. Die Zellen werden vor der Einkapselung elektrisch in Serie verbunden, so dass Zellstrings und schließlich eine Zellmatrix entstehen.

Nachteil des Verfahrens ist ein erhöhter Materialaufwand, eine Verzögerung des Produktionsprozesses durch den Laminierschritt und ein erhöhtes Bruchrisiko der Zellen im Modul beim Einsatz dünner Wafer.

Die Lehre der WO 2004/095586 verzichtet auf die Einkapselung zugunsten einer Zellfixierung durch Vakuum-Andruck zwischen den Deckschichten und einer nur randseitigen Abdichtung. Hier sind die Fragen der Beständigkeit des Vakuums sowie der Kontaktstellen zwischen Glas, Zellen und Zellverbinder noch ungeklärt.

Die DE 197 52 678 A1 beschreibt eine Ausführung ohne Einkapselungsmaterial, bei der die Zellen punktuell an der Deckschicht fixiert sind. Die Mindestbeabstandung der beiden Deckschichten wird nicht beschrieben. Weiterhin müssen die Fixierungsstellen aufgrund der unterschiedlichen thermischen Ausdehnungskoeffizienten zwischen Zellen und Glas eine Dicke aufweisen, die die Wärmeabgabe der Zellen behindert.

Die JP 57-172777 A offenbart ein Solarzellenmodul enthaltend Solarzellen, welche zwischen zwei Glasplatten angeordnet sind und von den zwei Glasplatten über Elektroden und Abstandshalter beabstandet sind, wobei die Abstandshalter dadurch fixiert werden, indem der Freiraum zwischen den Spacern mit flüssigem Kunststoff aufgefüllt wird.

Ausgehend hiervon war es Aufgabe der vorliegenden Erfindung, die aus dem Stand der Technik bekannten Nachteile zu beseitigen und photovoltaische Module bereitzustellen, die eine minimale mechanische Belastung der photovoltaischen Zellen ermöglichen und dabei den hierfür erforderlichen Herstellungsaufwand zu reduzieren.

Diese Aufgabe wird durch das photovoltaische Modul mit den Merkmalen des Anspruchs 1 sowie durch das Verfahren zu dessen Herstellung mit den Merkmalen des Anspruchs 14 gelöst. Die weiteren abhängigen Ansprüche zeigen vorteilhafte Weiterbildungen auf.

Erfindungsgemäß wird ein photovoltaisches Modul bereitgestellt, das eine erste und eine zweite Deckschicht, eine zwischen diesen befindliche Anordnung von über Zellverbindern verbundenen photovoltaischen Zellen sowie eine das photovoltaische Modul umlaufende Randabdichtung der Deckschichten aufweist. Das photovoltaische Modul weist dabei mindestens ein erstes und ein zweites lokalisiertes Kontaktelement (LKE) auf, welche die beiden Deckschichten beabstanden. Weiterhin ist mindestens eine photovoltaische Zelle oder mindestens ein Zellverbinder über das mindestens eine erste LKE mit mindestens einer Deckschicht stoffschlüssig verbunden. Ein weiteres Merkmal des erfindungsgemäßen Moduls ist es, dass mindestens eine photovoltaische Zelle das mindestens eine zweite LKE stoffschlüssig verbunden und/oder in Gleitkontakt angeordnet aufweist zur Beabstandung zu mindestens einer Deckschicht.

Die erfindungsgemäße Lösung beschreibt einen Modulaufbau, wobei im Gegensatz zum Stand der Technik auf eine volumenfüllende Einkapselung zwischen den Deckschichten verzichtet wird. Vielmehr erfolgt ein punk tueller Einsatz von Material (sog. lokalisierte Kontaktelemente, LKE) zur Fixierung, Beabstandung und gegebenenfalls Aussteifung, bei einem ansonsten gasgefüllten, randseitig abgedichteten Modul.

Die Erfindung basiert auf dem Grundgedanken, die Zellen über jeweils maximal eine starre Anbindung so zu fixieren, dass thermische Ausdehnungsunterschiede zwischen Zelle und Deckschicht nicht zu kritischen Spannungen führen. Dies kann beispielsweise durch eine einzelne Haftstelle zwischen photovoltaischer Zelle und Deckschicht realisiert werden, wobei der Rest der Zellfläche in tangentialer Richtung frei beweglich ist.

Erfindungsgemäß weist das mindestens eine zweite LKE ein Gleitlager zur Herstellung eines Gleitkontaktes mit Deckschichten und ein Festlager zur stoffschlüssigen Verbindung der mindestens einen Deckschicht mit der mindestens einen photovoltaischen Zelle auf. Die stoffschlüssige Verbindung der Festlager basiert dabei vorzugsweise auf physikalischen und/oder chemischen Wechselwirkungen. Hierzu zählen beispielsweise Klebe-, Löt- oder Schweißverbindungen.

Für ein lokales Kontaktelement, das ein Gleitlager aufweist, ist es bevorzugt, wenn sich der Querschnitt des LKE zum Gleitlager hin verjüngt. Dies ermöglicht eine gewisse Beweglichkeit des lokalen Kontaktelements.

Das lokalisierte Kontaktelement besteht oder enthält vorzugsweise ein organisches oder anorganisches Elastomer, z.B. auch ein geschäumtes Material, zum Ausgleich von Abstandsänderungen zwischen den Deckschichten.

Das lokalisierte Kontaktelement weist vorzugsweise eine Dicke im Bereich von 0,001 bis 5 mm, bevorzugt von 0,01 bis 0,5 mm und besonders bevorzugt von 0,1 bis 0,3 mm auf.

Das lokalisierte Kontaktelement kann dabei vorzugsweise mit beiden Deckschichten und einer photovoltaischen Zelle oder, in einer weiteren bevorzugten Ausführungsform, mit beiden Deckschichten und einem Zellverbindern in Verbindung stehen.

Die flächige Ausdehnung der LKE auf der photovoltaischen Zelle macht einen Flächenanteil von ≤ 10 %, bevorzugt ≤ 5 % und besonders bevorzugt ≤ 2 % der photovoltaischen Zelle aus.

Es ist weiterhin bevorzugt, dass die erste Deckschicht und die lokalisierten Kontaktelemente, die zwischen der ersten Deckschicht und den photovoltaischen Zellen liegen, im Wellenlängenbereich von 300 bis 1200 nm im Wesentlichen transparent sind, so dass Sonnenstrahlung ungestört auf die Solarzellen treffen kann.

Die Zellverbinder zwischen den photovoltaischen Zellen sind vorzugsweise elektrisch und mechanisch mit den photovoltaischen Zellen verbunden. Hierbei ist es auch möglich, dass der Zellverbinder ein Entspannungselement darstellt, das einen Ausgleich lateraler Bewegungen der photovoltaischen Zellen ermöglicht. Hierzu zählen insbesondere Elemente mit einer zumindest eindimensionalen Federwirkung. Das Entspannungselement kann dabei vorzugsweise bogenförmig, s-förmig und/oder gewinkelt sein.

Eine weitere bevorzugte Ausführungsform sieht vor, dass ein mit beiden Deckschichten in Kontakt stehendes, lokalisiertes Kontaktelement mit einem Entspannungselement, das über mindestens zwei Verbindungsstellen an mindestens zwei benachbarten Solarzelle angeordnet ist, verbunden ist.
Entspannungselemente, die mit Zellverbindern in Verbindung stehen, verringern Krafteinwirkung auf die photovoltaische Zelle, beispielsweise aufgrund von unterschiedlicher thermischer Ausdehnung oder von Moduldurchbiegung.

Vorzugsweise sind die lokalisierten Kontaktelemente zur Beabstandung der Deckschichten so dimensioniert, dass sie unter üblichen Drucklasten einen unmittelbaren Kontakt der Deckschichten mit den photovoltaischen Zellen verhindern.

Eine weitere bevorzugte Ausführungsform sieht vor, dass mindestens ein lokalisiertes Kontaktelement einen Zellverbinder mit einer Deckschicht derart verbindet, dass in der näheren Umgebung des Angriffspunktes am Zellverbinder keine stoffschlüssige Verbindung zwischen Zellverbinder und photovoltaischer Zelle besteht.

Grundsätzlich weist das erfindungsgemäße photovoltaische Modul somit unterschiedliche lokalisierte Kontaktelemente auf, die sich hinsichtlich der Art des Kontaktes mit den anderen Bauelementen unterscheiden.

Für die Fixierung kann das lokalisierte Kontaktelement ein beidseitig haftendes Element oder eine reine Klebemasse sein, die schlüssige Verbindungen zwischen Zelle und Deckschicht erzeugt. Die Haftstelle(n) befinden sich innerhalb eines kleinen, kompakten Flächenausschnitts, wodurch sich Unterschiede im thermischen Ausdehnungskoeffizienten zwischen Zelle und Deckschicht auch mit sehr dünnen Klebstoff-Schichten ausgleichen lassen.

Eine zweite Variante des als Haftelement ausgestalteten lokalisierten Kontaktelementes betrifft Verbindungen von Zellverbinder und Deckschicht.

Die lokalisierten Kontaktelemente, deren Funktion die Beabstandung der Deckschichten ist, weisen Gleitstellen- und/oder Haftstellen auf. Sind derartige lokalisierte Kontaktelemente im Bereich einer photovoltaischen Zelle angeordnet, so kann eine Gleitstelle auf der gegenüber liegenden Seite zur Haftstelle vorgesehen werden. So wird sichergestellt, dass die photovoltaische Zelle bei geringer Verformung/Verlagerung der Deckschichten nur senkrechte Druckkräfte erfährt, wodurch keine nennenswerten Scherkräfte auftreten.

Sind die zur Beabstandung der Deckschichten lokalisierten Kontaktelemente im Bereich zwischen den photovoltaischen Zellen angeordnet, so kann eine Gleit- oder Haftstelle direkt zwischen beiden Deckschichten ausgebildet sein. Durch Haftstellen lässt sich der Verbund der Deckschichten zusätzlich aussteifen, bei reinen Gleitstellen bleibt der Verbund hingegen statisch lose.

Bevorzugt ist eine Fixierung der Zellen in geringem Abstand zur ersten Deckschicht, um die Wärmeabgabe zu erleichtern.

Für die Leistung des Moduls ist es vorteilhaft,
- die Zellen mit einem geringen Abstand zu den Deckschichten, insbesondere zu der oberen Deckschicht anzuordnen, weil die Wärme dann besser nach außen durchgeleitet wird und die Zelltemperatur niedriger bleibt,
- die obere Deckschicht beidseitig mit reflexionsmindernden Eigenschaften (Beschichtung, Strukturierung) zu versehen,
- die Zellen gegen Gas, d.h. ein Medium mit Brechungsindex 1 zu entspiegeln.

Erfindungsgemäß wird ebenso ein Verfahren zur Herstellung eines photovoltaischen Moduls, wie es zuvor beschrieben wurde, bereitgestellt, bei dem die lokalisierten Kontaktelemente in flüssiger oder pastöser Form auf mindestens einer Deckschicht und mindestens einer photovoltaischen Zelle aufgebracht und anschließend thermisch oder photochemisch ausgehärtet werden. Die lokalisierten Kontaktelemente in flüssiger bzw. pastöser Form werden dabei vorzugsweise gedruckt, gesprüht und/oder dosiert.

Anhand der nachfolgenden Figuren soll der erfindungsgemäße Gegenstand näher erläutert werden, ohne diesen auf die hier gezeigten speziellen Ausführungsformen einschränken zu wollen.
Fig. 1 zeigt eine erfindungsgemäße Variante im Querschnitt.
Fig. 2 zeigt eine erfindungsgemäße Variante in Aufsicht.
Fig. 3 zeigt eine weitere erfindungsgemäße Variante in Aufsicht.
Fig. 4 zeigt in einer schematischen Darstellung verschiedene Varianten für lokalisierte Kontaktelemente, die in einem einzigen System integriert sind.

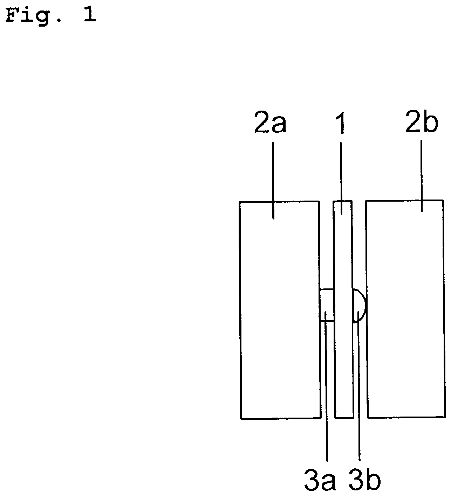

Fig. 1 zeigt eine bevorzugte Ausführung im Querschnitt mit einer Zelle 1, den Deckschichten 2a und 2b, einem lokalisierten Kontaktelement mit Hafteigenschaften 3a und einem lokalisierten Kontaktelement mit Gleiteigenschaften 3b. Das Gleitelement liegt hinter dem Haftelement und überträgt dadurch Drucklasten zwischen den Deckschichten senkrecht zur Zellfläche. Durch die Gleitfläche werden Scherspannungen an der Zelle vermieden.

Das lokalisierte Kontaktelement mit Hafteigenschaften 3a kann als trägerloser Klebefilm ausgebildet sein, das lokalisierte Kontaktelement mit Gleiteigenschaften 3b als geschäumtes Polymer mit einseitig angeordneter Klebeschicht.

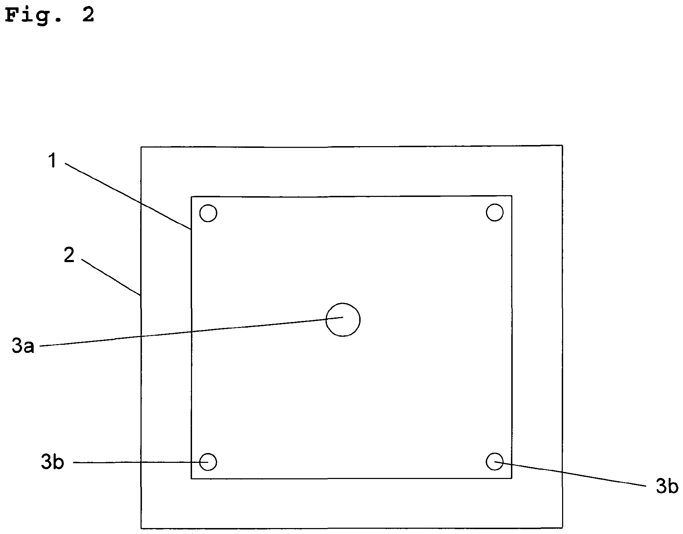

Fig. 2 zeigt eine bevorzugte Ausführung in Aufsicht mit einer Zelle 1, einer dahinter liegenden Deckschicht 2, einem zentral angeordneten lokalisierten Kontaktelement mit Hafteigenschaften 3a zur davor liegenden Deckschicht, sowie vier lokalisierten Kontaktelementen mit Gleiteigenschaften 3b.

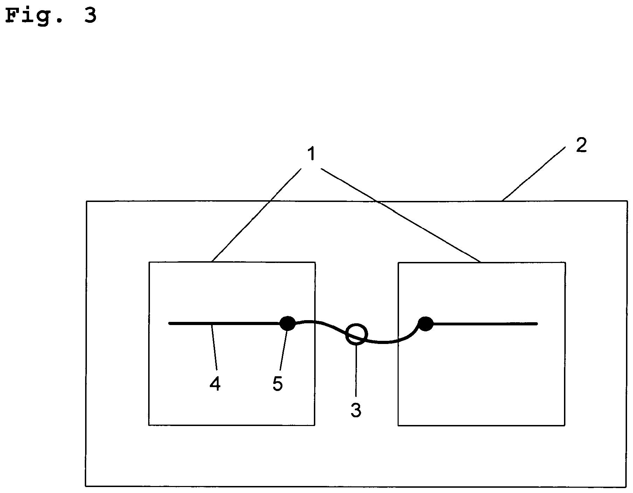

Fig. 3 zeigt eine bevorzugte Ausführung, bei der der Zellverbinder 4 zwischen seiner ersten Verbindungsstelle 5 zur Zelle und dem Haftelement 3 mit einem (hier bogenförmigem) Entspannungselement versehen ist. Der Zellverbinder 4 ist über das Haftelement 3 auf einer Deckschicht 2 fixiert. Das Haftelement 3 kann gleichzeitig die beiden Deckschichten beabstanden und/oder kann die beiden Deckschichten miteinander fest verbinden, so dass eine Aussteifung des Verbundes erfolgt.

Das lokalisierte Kontaktelement mit Hafteigenschaften zwischen Zellverbinder und Deckschicht kann auch im Bereich der Zelle angeordnet sein. Optional kann es zusätzlich mit einer Verbindungsstelle zwischen Zellverbinder und Zelle zusammenfallen.

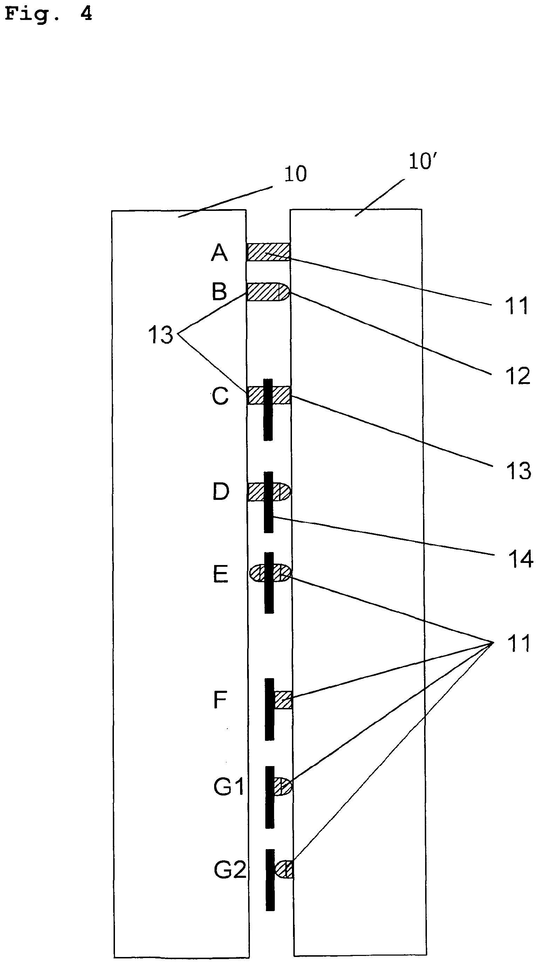

In Fig. 4 sind verschiedene Varianten für die Anordnung lokalisierter Kontaktelemente dargestellt. Zwischen den Deckschichten 10 und 10' ist in der Variante A zunächst ein lokales Kontaktelement 11 dargestellt, das an beiden Enden Hafteigenschaften besitzt und so eine stoffschlüssige Verbindung mit den Deckschichten ermöglicht. Die Variante B zeigt ein lokales Kontaktelement, das auf der einen Seite ein Gleitlager 12 und auf der anderen Seite ein stoffschlüssig verbundenes Festlager 13 aufweist. Dabei ist es vorteilhaft, wenn sich der Querschnitt des lokalen Kontaktelementes zum Gleitlager 12 hin verjüngt. Die Variante C stellt ein lokales Kontaktelement mit Festlager 13 an beiden Enden dar, in das eine Solarzelle oder ein Zellverbinder 14 integriert ist. Die Variante D unterscheidet sich von der Variante C dadurch, dass das lokale Kontaktelement an der einen Oberfläche ein Gleitlager 12 aufweist. Die Variante E unterscheidet sich von der Variante D dadurch, dass hier das lokalisierte Kontaktelement zwei Gleitflächen aufweist. In der Variante F ist die Solarzelle oder ein Zellverbinder 14 mittels eines lokalen Kontaktelementes 11 an einer Deckschicht befestigt, wobei das lokale Kontaktelement an beiden Seiten Festlager aufweist. Die Varianten G1 und G2 unterscheiden sich von der Variante F dadurch, dass hier das lokalisierte Kontaktelement zur Deckschicht bzw. zur Solarzelle oder zum Zellverbinder hin ein Gleitlager 12 aufweist.

## Patentansprüche

1. Photovoltaisches Modul enthaltend eine erste und eine zweite Deckschicht (2a, 2b), eine zwischen diesen befindliche Anordnung von über Zellverbindern (4) verbundenen photovoltaischen Zellen (1) sowie eine das photovoltaische Modul umlaufende Randabdichtung der Deckschichten,
wobei das Modul mindestens ein erstes und ein zweites lokalisiertes Kontaktelement (LKE)(3a, 3b) aufweist, welche die beiden Deckschichten (2a, 2b) beabstanden,
mindestens eine photovoltaische Zelle (1) oder mindestens ein Zellverbinder (4) über das mindestens eine erste LKE (3a) mit mindestens einer Deckschicht (2a, 2b) stoffschlüssig verbunden ist und dass mindestens eine photovoltaische Zelle (1) das mindestens eine zweite LKE (3b) stoffschlüssig verbunden oder in Gleitkontakt angeordnet aufweist zur Beabstandung zu mindestens einer Deckschicht (2a, 2b), **dadurch gekennzeichnet, dass**
die flächige Ausdehnung der LKE (3a, 3b) auf der photovoltaischen Zelle (1) einen Flächenanteil von ≤ 10 % der photovoltaischen Zelle ausmacht und dass
das mindestens eine zweite LKE (3b)
i) ein Gleitlager (12) zur Herstellung eines Gleitkontaktes mit der mindestens einen Deckschicht (2a, 2b) oder mit der mindestens einen photovoltaischen Zelle (1); und
ii) ein Festlager (13) zur stoffschlüssigen Verbindung mit der mindestens einen Deckschicht (2a, 2b) oder mit der mindestens einen photovoltaischen Zelle (1);
aufweist.

2. Photovoltaisches Modul nach einem der vorhergehenden Ansprüche, **dadurch gekennzeichnet, dass** die stoffschlüssigen Verbindung des Festlagers (13) auf physikalischen und/oder chemischen Wechselwirkungen basiert, insbesondere eine Klebe-, ein Löt- oder eine Schweißverbindung ist.

3. Photovoltaisches Modul nach einem der vorhergehenden Ansprüche, **dadurch gekennzeichnet, dass** die LKE (3a, 3b) aus einem organischen oder anorganischen Elastomer, bevorzugt einem geschäumten Material, zum Ausgleich von Abstandsänderungen zwischen den Deckschichten (2a, 2b) bestehen oder dieses enthalten.

4. Photovoltaisches Modul nach einem der vorhergehenden Ansprüche, **dadurch gekennzeichnet, dass** die LKE (3a, 3b) eine Dicke im Bereich von 0,001 bis 5 mm, bevorzugt von 0,01 bis 0,5 mm und besonders bevorzugt von 0,1 bis 0,3 mm aufweisen.

5. Photovoltaisches Modul nach einem der vorhergehenden Ansprüche, **dadurch gekennzeichnet, dass** mindestens eines der LKE (3a, 3b) mit beiden Deckschichten (2a, 2b) und einer photovoltaischen Zelle (1) oder einem Zellverbinder (4) in Verbindung steht.

6. Photovoltaisches Modul nach einem der vorhergehenden Ansprüche, **dadurch gekennzeichnet, dass** die flächige Ausdehnung der LKE (3a, 3b) auf der photovoltaischen Zelle (1) einen Flächenanteil ≤ 5% und bevorzugt ≤ 2% der Zelle (1) ausmacht.

7. Photovoltaisches Modul nach einem der vorhergehenden Ansprüche, **dadurch gekennzeichnet, dass** die erste Deckschicht (2a, 2b) und die LKE (3a, 3b), die zwischen der ersten Deckschicht (2a, 2b) und den photovoltaischen Zellen (1) liegen, im Wellenlängenbereich von 300 bis 1200 nm im Wesentlichen transparent sind.

8. Photovoltaisches Modul nach einem der vorhergehenden Ansprüche, **dadurch gekennzeichnet, dass** der Zellverbinder (4) elektrisch und mechanisch mit der photovoltaischen Zelle (1) verbunden ist.

9. Photovoltaisches Modul nach einem der vorhergehenden Ansprüche, **dadurch gekennzeichnet, dass** der Zellverbinder (4) ein Entspannungselement ist, das einen Ausgleich lateraler Bewegungen der photovoltaischen Zellen (1) ermöglicht, insbesondere ein Element mit einer zumindest eindimensionalen Federwirkung, wobei das Entspannungselement bevorzugt bogenförmig, s-förmig und/oder gewinkelt zur Bereitstellung der zumindest eindimensionalen Federwirkung ist.

10. Photovoltaisches Modul nach einem der Ansprüche 8 oder 9, **dadurch gekennzeichnet, dass** mindestens ein mit beiden Deckschichten (2a, 2b) in Kontakt stehendes, lokalisiertes Kontaktelement (11) mit einem Entspannungselement, das über mindestens zwei Verbindungsstellen an mindestens zwei benachbarten Solarzellen (1) angeordnet ist, verbunden ist.

11. Photovoltaisches Modul nach einem der vorhergehenden Ansprüche, **dadurch gekennzeichnet, dass** das mindestens eine zweite lokale Kontaktelement (3b) einen sich zum Gleitlager (12) verjüngenden Querschnitt aufweist.

12. Photovoltaisches Modul nach einem der vorhergehenden Ansprüche, **dadurch gekennzeichnet, dass** die LKE (3a, 3b) zur Beabstandung der Deckschichten (2a, 2b) so dimensioniert sind, dass sie unter üblichen Drucklasten einen unmittelbaren Kontakt der Deckschichten (2a, 2b) mit den photovoltaischen Zellen (1) verhindern.

13. Photovoltaisches Modul nach einem der vorhergehenden Ansprüche, **dadurch gekennzeichnet, dass** das mindestens eine erste LKE (3a) den Zellverbinder (4) mit einer Deckschicht (2a, 2b) derart verbindet, dass in der näheren Umgebung des Angriffspunktes am Zellverbinder (4) keine stoffschlüssige Verbindung zwischen Zellverbinder (4) und photovoltaischer Zelle (1) besteht.

14. Verfahren zur Herstellung eines photovoltaischen Moduls nach einem der vorhergehenden Ansprüche, bei dem die lokalisierten Kontaktelemente (3a, 3b) in flüssiger oder pastöser Form auf mindestens einer Deckschicht (2a, 2b) und mindestens einer photovoltaischen Zelle (1) aufgebracht und anschließend thermisch oder photochemisch ausgehärtet werden, wobei die lokalisierten Kontaktelemente (3a, 3b) vorzugsweise gedruckt, gesprüht und/oder dosiert werden.

## Claims

1. Photovoltaic module comprising a first and a second cover layer (2a, 2b), an arrangement of photovoltaic cells (1) connected via cell connectors (4) located therebetween and peripheral seal of the cover layers surrounding the photovoltaic module,
wherein the module has at least one first and one second localised contact element (LKE) (3a, 3b), the two cover layers (2a, 2b),
at least one photovoltaic cell (1) or at least one cell connector (4) is connected integrally via the at least one first LKE (3a) to at least one cover layer (2a, 2b) and
at least one photovoltaic cell (1) has the at least one second LKE (3b) being connected integrally or disposed in sliding contact in order to form a spacing relative to at least one cover layer (2a, 2b), **characterised in that**
the surface expansion of the LKE (3a, 3b) on the photovoltaic cell (1) constitutes a surface proportion of ≤ 10% of the photovoltaic cell and **in that**
the at least one second LKE (3b) has
i) a sliding bearing (12) for production of a sliding contact to the at least one cover layer (2a, 2b) or the at least one photovoltaic cell (1); and
ii) a stationary bearing (13) for integral connection to the at least one cover layer (2a, 2b) or the at least one photovoltaic cell (1).

2. Photovoltaic module according to one of the preceding claims, **characterised in that** the integral connection of the stationary bearing (13) is based on physical and/or chemical interactions, in particular an adhesive, a solder or a weld connection.

3. Photovoltaic module according to one of the preceding claims, **characterised in that** the LKE (3a, 3b) consist of an organic or inorganic elastomer, preferably a foamed material, for compensation of spacing changes between the cover layers (2a, 2b) or comprise this.

4. Photovoltaic module according to one of the preceding claims, **characterised in that** the LKE (3a, 3b) have a thickness in the range of 0.001 to 5 mm, preferably of 0.01 to 0.5 mm and particularly preferred of 0.1 to 0.3 mm.

5. Photovoltaic module according to one of the preceding claims, **characterised in that** at least one of the LKE (3a, 3b) is connected to both cover layers (2a, 2b) and to one photovoltaic cell or to one cell connector (4).

6. Photovoltaic module according to one of the preceding claims, **characterised in that** the surface expansion of the LKE (3a, 3b) on the photovoltaic cell (1) constitutes a surface proportion of ≤ 5% and preferably ≤ 2%, of the photovoltaic cell (1).

7. Photovoltaic module according to one of the preceding claims, **characterised in that** the first cover layer (2a, 2b) and the LKE (3a, 3b) which are located between the first cover layer (2a, 2b) and the photovoltaic cells (1) are essentially transparent in the wavelength range of 300 to 1,200 nm.

8. Photovoltaic module according to one of the preceding claims, **characterised in that** the cell connector (4) is connected electrically and mechanically to the photovoltaic cell (1).

9. Photovoltaic module according to one of the preceding claims, **characterised in that** the cell connector (4) is a stress-relieving element which enables compensation of lateral movements of the photovoltaic cells (1), in particular an element having an at least one-dimensional spring effect, wherein the stress relieving element is arcuate, s-shaped and/or angled in order to provide the at least one-dimensional spring effect.

10. Photovoltaic module according to one of the claims 8 or 9, **characterised in that** at least one localised contact element (11), which is in contact with both cover layers (2a, 2b), is connected to a stress-relieving element which is disposed over at least two connection points to at least two adjacent solar cells (1).

11. Photovoltaic module according to one of the preceding claims, **characterised in that** the at least one second local contact element (3b) has a cross-section tapering towards the sliding bearing (12).

12. Photovoltaic module according to one of the preceding claims, **characterised in that** the LKE (3a, 3b) are dimensioned for the spacing of the cover layers (2a, 2b) such that they prevent a direct contact of the cover layers (2a, 2b) with the photovoltaic cells (1) under normal pressure loads.

13. Photovoltaic module according to one of the preceding claims, **characterised in that** the at least one first LKE (3a) connects the cell connector (4) to a cover layer (2a, 2b) such that no integral connection between cell connector (4) and photovoltaic cell (1) exists in the immediate vicinity of the contact point on the cell connector (4).

14. Method for the production of a photovoltaic module according to one of the preceding claims, in which the localised contact elements (3a, 3b) are applied on at least one cover layer (2a, 2b) and at least one photovoltaic cell (1) in liquid or pasty form and subsequently are cured thermally or photochemically, wherein the localised contact elements are preferably printed, sprayed and/or metered.

## Revendications

1. Module photovoltaïque contenant une première et une deuxième couches de recouvrement (2a, 2b), un agencement, se trouvant entre celles-ci, de cellules photovoltaïques (1) reliées par l'intermédiaire de connecteurs de cellules (4), ainsi qu'un joint d'étanchéité de bord des couches de recouvrement entourant le module photovoltaïque,
le module comprenant au moins un premier et un deuxième éléments de contact localisés (LKE) (3a, 3b) qui écartent les deux couches de recouvrement (2a, 2b),
au moins une cellule photovoltaïque (1) ou au moins un connecteur de cellule (4) étant relié par l'intermédiaire de l'au moins un premier LKE (3a) avec au moins une couche de recouvrement (2a, 2b) par liaison de matière et en ce que
au moins une cellule photovoltaïque (1) comprend l'au moins un deuxième LKE (3b) relié par liaison de matière ou disposé en contact glissant pour l'écartement par rapport à au moins une couche de recouvrement, **caractérisé en ce que**
l'extension plane des LKE (3a, 3b) constitue, sur la cellule photovoltaïque (1), une part de surface ≤ 10 % de la cellule photovoltaïque et **en ce que**
l'au moins un deuxième LKE (3b)
i. comprend un palier lisse (12) pour l'établissement d'un contact glissant avec l'au moins une couche de recouvrement (2a, 2b) ou avec l'au moins une cellule photovoltaïque (1) ; et
ii. comprend un palier fixe (13) pour la liaison par liaison de matière avec l'au moins une couche de recouvrement (2a, 2b) ou avec l'au moins une cellule photovoltaïque (1).

2. Module photovoltaïque selon l'une des revendications précédentes, **caractérisé en ce que** la liaison par liaison de matière du palier fixe (13) est basée sur des interactions physiques et/ou chimiques, plus particulièrement est une liaison par collage, brasage ou soudure.

3. Module photovoltaïque selon l'une des revendications précédentes, **caractérisé en ce que** les LKE (3a, 3b) sont constitués ou contiennent un élastomère organique ou inorganique, de préférence un matériau alvéolaire, pour la compensation de variations de distances entre les couches de recouvrement (2a, 2b).

4. Module photovoltaïque selon l'une des revendications précédentes, **caractérisé en ce que** les LKE (3a, 3b) présentent une épaisseur de l'ordre de 0,001 à 5 mm, de préférence de 0,01 à 0,5 mm et plus particulièrement de préférence de 0,1 à 0,3 mm.

5. Module photovoltaïque selon l'une des revendications précédentes, **caractérisé en ce qu'**au moins un des LKE (3a, 3b) est relié avec les deux couches de recouvrement (2a, 2b) et une cellule photovoltaïque (1) ou un connecteur de cellule (4).

6. Module photovoltaïque selon l'une des revendications précédentes, **caractérisé en ce que** l'extension plane des LKE (3a, 3b) sur la cellule photovoltaïque (1) constitue une part de surface ≤ 5 % et de préférence ≤ 2 % de la cellule (1).

7. Module photovoltaïque selon l'une des revendications précédentes, **caractérisé en ce que** la première couche de recouvrement (2a, 2b) et les LKE (3a, 3b), qui se trouvent entre la première couche de recouvrement (2a, 2b) et les cellules photovoltaïques (1), sont transparentes dans le domaine de longueurs d'ondes de 300 à 1200 nm.

8. Module photovoltaïque selon l'une des revendications précédentes, **caractérisé en ce que** le connecteur de cellule (4) est relié de manière électrique et mécanique avec la cellule photovoltaïque (1).

9. Module photovoltaïque selon l'une des revendications précédentes, **caractérisé en ce que** le connecteur de cellule (4) est un élément de détente, qui permet une compensation des mouvements latéraux des cellules photovoltaïques (1), plus particulièrement un élément avec une action élastique au moins monodimensionnelle, l'élément de détente présentant de préférence une forme d'arc de cercle et/ou est plié pour la réalisation de l'action élastique au moins monodimensionnelle.

10. Module photovoltaïque selon l'une des revendications 8 ou 9, **caractérisé en ce qu'**au moins un élément de contact localisé (11), en contact avec les deux couches de recouvrement (2a, 2b), est relié avec un élément de détente, qui est disposé, par l'intermédiaire d'au moins deux points de connexion, au niveau d'au moins deux cellules photovoltaïques (1) adjacentes.

11. Module photovoltaïque selon l'une des revendications précédentes, **caractérisé en ce que** l'au moins un deuxième élément de contact local (3b) présente une section se rétrécissant vers le palier lisse (12).

12. Module photovoltaïque selon l'une des revendications précédentes, **caractérisé en ce que** les LKE (3a, 3b) pour l'écartement des couches de recouvrement (2a, 2b) sont dimensionnés de façon à empêcher, sous des charges de pression habituelles, un contact direct des couches de recouvrement (2a, 2b) avec les cellules photovoltaïques (1).

13. Module photovoltaïque selon l'une des revendications précédentes, **caractérisé en ce que** l'au moins un premier LKE (3a) relie le connecteur de cellule (4) avec une couche de recouvrement (2a, 2b) de façon à ce que, à proximité immédiate du point d'attaque sur le connecteur de cellule (4), il n'existe aucune liaison par liaison de matière entre le connecteur de cellule (4) et la cellule photovoltaïque (1).

14. Procédé de fabrication d'un module photovoltaïque selon l'une des revendications précédentes, dans lequel les éléments de contact localisés (3a, 3b) sont appliqués sous forme liquide ou pâteuse sur au moins une couche de recouvrement (2a, 2b) et au moins une cellule photovoltaïque (1) puis sont durcis de manière thermique ou photochimique, les éléments de contact localisés (3a, 3b) étant de préférence imprimés, pulvérisés et/ou dosés.
